# EUROPEAN PATENT SPECIFICATION

(11) **EP 0 618 244 B1**
(45) Date of publication and mention of the grant of the patent: **15.07.1998**
(21) Application number: 94302274.9
(22) Date of filing: 29.03.1994
(51) Int. Cl.: C08G 18/79, C08G 18/82, C09D 175/14, C08F 299/06

(54) **Multiple curable composition and use thereof**
Härtbare Mehrfachzusammensetzung und Verwendung
Composition multiple durcissable et son utilisation

(30) Priority: 29.03.1993 US 38772
(43) Date of publication of application: 05.10.1994
(73) Proprietor: NATIONAL STARCH AND CHEMICAL INVESTMENT HOLDING CORPORATION, Wilmington, Delaware 19850 (US)
(72) Inventor: Kyle, David Ray, Columbia, Maryland 21046 (US)
(74) Representative: Jones, Helen Marjorie Meredith

(56) References cited:
- EP-A- 0 100 688
- EP-A- 0 149 867
- EP-A- 0 347 610
- EP-A- 0 553 007
- EP-A- 0 603 046
- WO-A-93/20137
- US-A- 4 391 686
- US-A- 4 415 604

## Description

This invention relates generally to an ultraviolet (UV) light curable conformal coating composition having two built-in secondary curing mechanisms. The composition being useful as a protective coating for electronic assemblies and as encapsulant for electronic parts. By "conformal coating", it is meant a coating which is applied so as to conform to the features of the surface to be coated, especially surfaces of electronic circuit boards. By "secondary curing", it is meant the curing which occurs through two mechanisms in shadowed areas of a board.

Conformal coatings were originally made to protect military and aerospace electronic assemblies from environmental factors such as humidity, dust and chemical contaminants. These environmental factors cause unprotected assemblies with delicate circuitry to malfunction because of corrosion and electrical shorting. As the electronic packaging becomes denser with fine conductor spacings, the assemblies are even more sensitive to the environmental factors. In addition, the increasing use of electronics in transportation and general industrial applications caused the increased use of conformal coatings, mainly for the protection of the electronics from their harsh end-use environments.

The most damaging and usually the most prevalent contaminant generally is considered to be moisture or humidity. Excessive moisture or humidity will drastically lower insulation resistance between conductors, accelerate high-voltage breakdown and dendritic growth, and corrode conductors. Other contaminants which may damage printed circuit boards include various chemicals such as residues of the manufacturing process, such as solder fluxes, organic solvents, release agents, metal particles and marking inks, and contaminants which inadvertently may be deposited by human handling such as body greases, fingerprints, cosmetics and food stains. Ambient operating conditions may also contribute a variety of contaminants such as salt spray, dirt and dust, oil, fuel, acid, corrosive vapor, and fungus. In all but the more severe cases, the destructive action of these contaminants can be effectively eliminated by provision of a good conformal coating.

In addition to providing protection from contaminants, conformal coatings also provide a certain degree of protection to mechanical shock, vibration and tampering.

Historically, the first commercial conformal coatings were one and two-part systems whose main constituents were acrylic, epoxy, silicone or polyurethane resins. These resins were usually dissolved in solvents so they could be applied to the parts by spray, dip or brush. These first generation coatings had one or more disadvantages such as the need for mixing immediately before use and required the use of large amounts of solvents to lower the viscosity for application. They also usually required long drying or curing times that released large amounts of volatile organic compounds (VOCs) before the coated assemblies could be handled.

Some of these disadvantages were addressed with the introduction of ultraviolet (UV) curable conformal coatings. The UV curable coatings were generally solventless, one-part systems that cured tack-free to the touch, generally via a free-radical polymerization after exposure to UV light. This allowed immediate handling of the coated parts and so reduced the processing time and energy costs, as compared to the solvent based, thermally cured coatings. The application viscosity of these first generation UV curable coatings tended to be higher than solvent based systems. As a result, thin films were not easily applied.

The rapid transformation of a liquid composition into a crosslinked solid happened only to the areas exposed to the UV light and not in the shadowed area (e.g., under components). This shadowing became more of a problem as electronic assemblies with high component densities became more common. Therefore, a secondary cure mechanism such as heat was sometimes incorporated into acrylate, UV curable conformal coatings to polymerize these shadowed areas while maintaining one-part stability. But thermal cure schedules of temperatures of more than 100°C were required to complete this secondary curing process.

Various dual-curing conformal coating systems are known in the art, with each having its advantages and disadvantages.

For instance, two component dual curing systems, such as two component polyurethane systems, offer short curing times. See U. S. Patent 4,424,252 to Nativi et al. In particular, the '252 patent to Nativi discloses a two component system made by reacting a urethane acrylate with an aliphatic or aromatic polyisocyanate adduct. The coating then cures within 2 hours to a day through several mechanisms, one of which includes reaction between free isocyanates on the polyisocyanate adduct and atmospheric moisture. The curing mechanisms also include reaction between the isocyanate groups and the hydroxyl groups on the urethane acrylate. As a result of the latter reaction, however, this system, as well as other two component systems, e.g. see U. S. Patent 5,013,631 to Su, have a limited pot life (to about 48 hours or less), and therefore must be mixed just before use.

Certain one component systems avoid the pot life problems incurred by the two-component systems by avoiding use of any isocyanate reactive functional groups in the system. For instance, U. S. Patent 4,415,604 to Nativi discloses a one-component system which is made of an isocyanate-capped polyether diol and triol, an acrylate diluent and a photoinitiator. However, because the isocyanate-capped diols and triols are based on hydrophilic polyethers, the resulting coating loses some hydrolytic stability and resistance to moisture. As a result, the coating is not as effective in humid environments.

Another type of dual-curing one-component conformal coating involves a curing mechanism other than an isocyanate reaction. For instance, U.S. 4,451,523 to Nativi et al. discloses a one-component composition comprising a urethane-(meth)acrylate, an allyl-group containing (meth)acrylate monomer, a nonallylic (meth)acrylate diluent, photoinitiator and a metal drier. The crosslinking of the allylic compounds in the presence of metal driers provides the second curing mechanism in addition to UV curing of a (meth)acrylate. However, this system may contribute metal ionic species which reduce the electrical properties of the coating. These species could also cause degradation of electronic components by promoting an electrical pathway between closely packed components.

It is also known to employ dual curing coatings in areas other than electronics. For instance, radiation dual curable coatings have been employed in the automobile industry. See U. S. 4,173,682 to Noomen et al. In particular Noomen et al. disclose a two-component automobile coating system comprising (i) an isocyanate group-containing adduct prepared from a (meth)acrylic hydroxy ester and a polyisocyanate and (ii) a polyfunctional hydroxy compound. However, not only does this two-component system suffer from the disadvantages discussed above in terms of the electronic coatings, it also apparently suffers from long ambient cure times, e.g., a few days, when compared to cure times for other two-component systems. In addition, some of the isocyanates disclosed by Noomen et al., e.g., the adduct of hexamethylene diisocyanate and water, contain biuret linkages. Compounds containing these linkages are not the most thermal or "weather" stable. By "weather stable", it is meant stability under ambient humidity, temperature fluctuations and sunlight.

U. S. Patent 4,138,299 to Bolgiano discloses a one-component dual curing composition suitable for glossy, abrasion resistant floor coatings. Specifically Bolgiano discloses a one-component composition consisting essentially of an isocyanate (NCO) terminated prepolymer (prepared from an aliphatic isocyanate and a polyester diol and triol), and an acrylate diluent which contains no reactive hydroxyl groups. The NCO terminated prepolymer is also further reacted with sufficient hydroxy acrylate to cap 5 to 15% of the available NCO groups. The composition primarily cures through crosslinking of the acrylates' ethylenically unsaturated groups and secondarily through chain extension and crosslinking of the free NCO groups and water. However, as with the composition disclosed in the '604 patent to Nativi, Bolgiano's composition contains hydrophilic moieties, i.e. the polyester linkages. Accordingly, in humid environments the hydrolytic stability of the composition is not as effective.

Dual curing conformal coatings made of aliphatic polyisocyanates and hydroxyalkyl(meth)acrylates are disclosed in copending United States Application No. 811,417, filed December 20, 1991 and incorporated herein as if set forth in full.

As is evident from the above discussion and as is well known in the art, no dual curing conformal coating is completely satisfactory for all applications due to the varying processing (e.g. processing speed, pot life and cure conditions) and end use demands (e.g. thermal characteristics, weathering and hydrolytic stability). Accordingly the intended application and the environment related to that application have typically dictated the particular formulation of the coating.

The present invention is a new UV curable conformal coating composition which has two secondary cure mechanisms and is a solventless, one-part storage stable, low viscosity liquid that rapidly crosslinks into a tack-free solid when exposure to UV light. This UV cure allows the coated part to be immediately handled and prevents run off of the liquid coating trapped in the shadowed areas. The coating in the shadowed areas is polymerized to a dry-to-the-touch solid upon standing in the open by exposure to either atmospheric moisture or heating.

The coating is made of an acryloisocyanate oligomer which is synthesized by reacting some of the isocyanate in an aliphatic polyisocyanate with hydroxy alkyl acrylate or methacrylate. The oligomer is used in combination with various mono and/or polyfunctional reactive acrylate and/or methacrylate reactive diluents, optionally a polymerisation initiator(s) of the photoinitiator type and an organic peroxide(s) of the peroxyester and/or peroxyketal type. The coating composition is UV curable, and also possesses two additional cure mechanisms.

A particular feature and advantage of the invention is that the UV radiation cure produces a rapid, "dry-to-the-touch" cure of all the exposed areas of the coating, thereby permitting substantially immediate handling of the coated products and maintaining the shape of the coating which might otherwise sag and creep, while the secondary cure mechanism provides a substantially complete cure of unexposed shadowed areas of the coating under conditions of ambient temperature and humidity or by heating to an elevated temperature sufficient to activate an organic peroxide. Another important feature of this invention is that, despite the presence of the peroxides, the thermal stability of the overall composition is maintained.

It is a specific object of this invention to formulate a multiple curing conformal coating composition having application and physical characteristics most suitable for electronic uses. However, the composition disclosed herein can also be used for other specific uses such as potting and adhesive compositions.

It is also an object to provide a coating composition having a relatively long pot life and good thermal, weather and hydrolytic stability.

A further object is to provide a means for controlling the cure rate of a conformal coating.

These objects and others which will be apparent from the detailed description below can be obtained from a one part curable composition comprising (a) an isocyanate adduct which is the reaction product of a polyisocyanate and a hydroxyalkyl (meth) acrylate, the adduct having (i) free isocyanate groups and (ii) free photopolymerisable ethylenically unsaturated groups, wherein the ethylenically unsaturated groups comprise in the range of 10 to 70% of the total of any free functional groups on said adduct; (b) reactive (meth) acrylate diluents; (c) optionally, photoinitiator, and (d) an organic peroxide or mixture of peroxides which are preferably of peroxyesters of peroxyketals.

To obtain a more thermal stable composition, a one part multiple curing composition comprising aliphatic isocyanate trimer having isocyanurate rings can be used.

The composition of the invention is unique and uniquely useful because it is curable by moisture, radiation and heat, due in part to the specific adduct described as component (a).

The composition of this invention can not only be used as a coating on electronic articles, but also other articles as well. Specifically, a composition as described above is applied to the article and then exposed to radiation to provide the primary cure. Secondary or tertiary cures result from the reaction of the composition's free isocyanate groups and water, or the organic peroxide's response to heat.

Accordingly there is also provided a method of providing a cured composition on an article wherein the method comprises (a) applying to the article the composition of the invention; (b) curing the composition at least partially by exposing it to radiation. Preferably the method additionally comprises (c) a secondary curing step wherein parts of the composition not exposed to radiation in step (b) are cured by initiating secondary curing. It is preferred that this secondary curing is initiated by the application of heat to the composition and/or by contacting the composition with moisture. If the application of heat is used heating is usually to an elevated temperature sufficient to activate an organic peroxide.

As indicated above, the composition of this invention is a one-component composition. By this term, it is meant that the composition is provided to the user as one formulation which is suitable for immediate use, and is relatively storage stable, e.g. at least thirty days at room temperature. As a result, the one-part composition should comprise (a) - (d) and should be substantially free of any free isocyanate reactive functional groups, e.g. hydroxyl groups. As discussed earlier, two-component systems are provided to the user as two formulations which require a metering and mixing step prior to use. Such compositions are generally not storage stable after mixing.

The isocyanate adduct designated as (a) above is the reaction product of a polyisocyanate and a hydroxyalkyl (meth) acrylate. As a result of this reaction, (a) not only has free isocyanate groups, but also has free ethylenically unsaturated groups.

Suitable polyisocyanates are those well known in the art. It is preferable that the polyisocyanate has 2 to 3 free isocyanate groups. For applications where appearance of the coating is not critical, suitable aromatic polyisocyanates include, but are not limited to, toluene diisocyanate, diphenylmethane-4,4'-diisocyanate, naphthalene diisocyanate, 3,3' bistoluene-diisocyanate and 5,5'-dimethyl-diphenylmethane-4,4'-diisocyanate. Adducts of the above-mentioned isocyanates are also suitable.

In applications where the appearance of the coating is critical, aliphatic polyisocyanates are preferred. Suitable aliphatic isocyanates include tetramethylene-1,4-diisocyanate, hexamethylene-1,6-diisocyanate, ω,ω-dipropylether diisocyanate, thiodipropyl diisocyanate, 1,2,4-trimethylhexane-1,6-diisocyanate, 2,4,4-trimethylhexane-1,6-diisocyanate, cyclohexyl-1,4-diisocyanate, isophorone diisocyanate, the adduct of 1 molecule of 1,4-butanediol and 2 molecules of isophorone diisocyanate, the adduct of 1 molecule of 1,4-butanediol and 2 molecules of hexamethylene diisocyanate, dicyclohexylmethane-4,4'-diisocyanate, dicyclohexyldimethylmethane-4,4'-diisocyanate, xylylene diisocyanate, 1,5-dimethyl(2,4-ω-diisocyanatomethyl)benzene, 1,5-dimethyl(2,4-107-diisocyanatoethyl)benzene, 1,3,5-trimethyl(2,4-ωdiisocyanatomethyl)benzene and 1,3,5-triethyl(2,4-ω-diisocyanatomethyl)benzene.

A preferable aliphatic polyisocyanate is a aliphatic isocyanate trimer having an isocyanurate ring. The trimer is preferably the trimerization product of hexamethylene diisocyanate having the structure below:

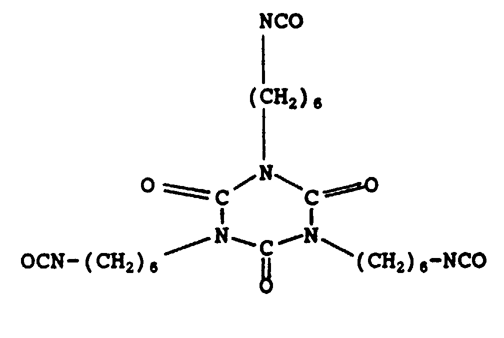

The above polyisocyanate is commercially available as DESMODUR® N-3300 polyisocyanate from Mobay.

Other suitable aliphatic isocyanate trimers include those prepared from isophorone diisocyanate and dicyclohexylmethane diisocyanate.

The aliphatic isocyanate trimers are preferable because conformal coatings prepared therefrom should be more thermal and weather stable than polyisocyanates which contain biuret linkages, e.g. the polyisocyanate supra prepared from hexamethylene diisocyanate and water. See the '682 Patent to Noomen et al. In fact, such trimers would be useful for not only conformal coatings consisting essentially of (a) - (d) mentioned above, but other conformal coatings as well.

The hydroxy alkyl (meth)acrylates suitable for reacting with the polyisocyanate include, but are not necessarily limited to, hydroxyethyl (meth)acrylate, 2-hydroxymethyl (meth)acrylate, hydroxybutyl (meth)acrylate (and isomers thereof) and 2-hydroxypropyl (meth)acrylate (and isomers thereof).

The formation of an adduct from a polyisocyanate and a hydroxy(meth)acrylate may generally be carried out by adding the reaction components together in any arbitrarily chosen way, optionally at elevated temperature. It is preferred that the reaction be carried out under anhydrous conditions at temperatures in the range of 5° to 100° C, more particularly in the range of 50° to 90° C. Generally the reaction components may be added together in any chosen way. However, the hydroxy-alkyl(meth)acrylate be added to the polyisocyanate, in several stages, if desired. The reaction will usually be carried out in the presence of an inert solvent, such as methylisobutyl ketone, toluene, xylene, or esters such as butyl acetate or ethyl glycol acetate, but the use of a solvent is not strictly necessary. Optionally the reaction between the isocyanate groups and the hydroxy groups may be carried out in the presence of a catalyst. Suitable examples of catalysts include tertiary amines and organic tin salts or zinc salts such as dibutyl tin dilaurate, tin octoate and zinc octoate. Mixtures of catalysts may also be used.

As indicated above, the amount of hydroxy alkyl methacrylate is added and the reaction carried out over a sufficient period of time to insure that at least 10% of the free functional groups on (a) are ethylenically unsaturated groups but no more than 70% with preferable amounts being in the range of 20 to 40%. In other words, the amount of hydroxy alkyl (meth)acrylate and the reaction time should be sufficient to terminate at least 10% of the free isocyanate groups on the polyisocyanate, but no more than 70%, with preferably 20 to 40% of the isocyanate groups being terminated.

Once the polyisocyanate adduct has been prepared, it is blended with at least one reactive acrylate or methacrylate("(meth)acrylate") diluent, and preferably two or more. Suitable diluents include those well known in the art and are exemplified by, but not necessarily limited to, isobornyl acrylate and methacrylate, isodecyl acrylate, tridecyl acrylate and methacrylate, phenoxyethyl acrylate, dicyclopentenylethoxy methacrylate, and dicyclopentenylethoxy acrylate. Others include trimethylolpropane ethoxylate triacrylate, dicyclopentadiene methacrylate and dicyclopentadiene acrylate, isobutyl methacrylate, and lauryl acrylate and methacrylate.

The blend can include additives. For instance, a photoinitiator or a blend of two or more photoinitiators or photocuring rate accelerators may be added. Suitable photoinitiators include, but are not necessarily limited to, ultraviolet (hereafter "UV") activated free radical generators and typically may be employed in amounts of about 1% to about 10% by weight of the coating composition. For example, the UV activated initiators may be selected from metal carbonyls of the formula Mₓ(CO)_{y} wherein M is a metal atom, x is 1 or 2, and y is an integer determined by the total valence of the metal atoms, generally 4 to 10. The preferred UV activated initiators are selected from (a) C₁₋₁₆ straight or branched chain alkyl diones; and (b) carbonyl compounds of the general formula R⁵(CO)R⁶ wherein R⁵ is a C₁₋₁₀ alkyl, aryl, aralkyl or alkaryl group, and R⁶ is R⁵ or hydrogen. In addition, R⁵ or R⁶ can contain any substituents which do not adversely affect the compound in serving its function. For example, R⁵ or R⁶ can be alpha-substituted with an alkyl, aryl, alkaryl, alkoxy or aryloxy radical, or with an amino or a mono- or dialkylamino derivative thereof, each of the above substituents containing up to about six carbon atoms. In addition, R⁵ and R⁶ taken together with carbonyl group(s) form an aromatic or heterocyclic ketone containing up to about 16 carbon atoms.

Specific examples include, but are not limited to, benzophenone, o-methoxy-benzophenone, acetophenone, o-methoxy-acetophenone, acenaphthenequinone, methyl ethyl ketone, valerophenone, hexanophenone, α-phenyl-butyrophenone, p-morpholinopropiophenone, dibenzosuberone, 4-morpholinobenzophenone, benzoin, benzoin methyl ether, 4-o-morpholinodeoxybenzoin, p-diacetylbenzene, 4-aminobenzophenone, 4'-methoxyacetophenone, α-tetralone, 9-acetylphenanthrene, 2-acetylphenanthrene, 10-thioxanthenone, 3-acetylphenanthrene, 3-acetylindole, 9-fluorenone, 1-indanone, 1,3,5-triacetylbenzene, thioxanthen-9-one, xanthene-9-one, 7-H-benz[de]anthracen-7-one, benzoin tetrahydropyranyl ether, 4,4'-bis(dimethylamino)benzophenone, 1'-acetonaphthone, 2'-acetonaphthone, acetonaphthone and 2,3-butanedione, benz[a]anthracene -7,12-dione, 2,2-dimethoxy-2-phenylacetophenone, α,α-diethoxy-acetophenone, α,α-dibutoxyacetophenone, etc. Singlet oxygen generating photosensitizers such as Rose Bengal, methylene blue, and tetraphenyl porphine may also be employed as photoinitiators. Polymeric initiators include poly(ethylene carbon monoxide) and oligo[2-hydroxy-2-methyl-1-[4-(1-methylvinyl)phenyl) propanone]. Preferred initiators include 4-morpholino-2-ethyl-2-dimethylamino-2-benzyl acetophenone, 2-isopropyltheoxanthone, and 2-methyl-1-[4-(methylthio)phenyl] -2-morpholinopropanone, available as Irgacure® 907 from Ciba. Use of a photoinitiator is preferable because it generally provides faster and more efficient initiation. When actinic radiation is used, the initiators may also provide initiation at longer wavelengths which are less costly to generate and less harmful.

It has been found that use of certain combinations of initiators result in improved surface cure. For example, a hydrogen-extracting photoinitiator such as a benzophenone or thioxanthone can be used with a dialkylamino benzoate co-initiator such as octyl-p-(dimethylamino)benzoate and ethyl-p-(dimethylamino)benzoate.

It is to be understood, however, that when energy sources, e.g., ionizing radiation, other than visible or ultraviolet light, are used to initiate the curing reaction, photocuring rate accelerators (i.e., photosensitizers, etc.) are not necessarily required in the formulation. As a practical matter, however, these materials are usually needed to produce a commercially feasible process.

It is preferred to add a thermal initiator to provide another curing mechanism and thereby increasing the flexibility of processes using the coating. The preferred thermal initiators are organic peroxides such as peroxyesters and peroxyketals. Some examples of peroxyesters that can be used alone or in combination with other free radical thermal and/or photo initiators, but not limited to the following:
(1) monoperoxyesters such as t-butyl peroxypiralate, t-amyl peroxypiralate, t-butyl peroxyisobutyrate, t-butyl peroxyneodecanoate, t-butyl peroxybenzoate, t-amyl peroxyneodecanoate, t-butyl peroctoate, t-amyl peroxy(2-ethylhexanoate);
(2) peroxycarbonates such as o-t-butyl-o-(2-ethylhexyl)monoperoxycarbonate;
(3) diperoxyesters such as 2,5-dimethyl-2,5-bis (2-ethylhexanoylperoxy)hexane, di-t-butyl diperoxyazelate.

Some examples of peroxyketals, also known as gemdiperoxides, that can be used alone or in combination with other free radical thermal and/or photo initiators include, but are not limited to the following: 1,1-bis(t-butylperoxy)-3,3,5-trimethylcyclohexane; 1,1-di(t-amylperoxy)cyclohexane; ethyl-3,3-di(t-butylperoxy)butyrate; ethyl-3,3-di(t-amylperoxy) butyrate; 2,2-bis(t-butylperoxy) butane; 2,2-di(t-amylperoxy) propane.

It is useful, but also not required, to incorporate an adhesion promoter into the composition when it is used as a coating or an adhesive. Suitable adhesion promoters include those known in the art. Suitable promoters include mono- and dicarboxylic acids which are capable of copolymerizing with the acrylate or methacrylate reactive diluents, well-known silane promoters, organic titanates and organic zirconates. The amount of promoter varies depending on the type used. Suitable amounts can be in the range of 0.01 to 20% of the composition.

Also optional is the inclusion of one or more chelators, crosslinking agents and/or polymerization inhibitors. Chelators and inhibitors are effective in amounts of about 0.1 to about 1% by weight of the total composition. Ethylenediamine tetraacetic acid and its sodium salt (Na₄ 1,1-ethylenebis-nitril methylidyne dipyridine) and beta-diketones are generally the most effective and are preferred. Cross-linking agents may be present in amounts from about zero to about 10% by weight of the total composition and include compounds such as copolymerizable di(meth)acrylates.

The inhibitor concentration left over in the monomers from manufacture is often high enough for good stability. However, to insure maximum pot life, the proportions mentioned about (about 0.1 to about 1% by weight of the composition) are recommended. Suitable inhibitors include the group consisting of hydroquinones, benzoquinones, naphthoquinones, phenanthraquinones, anthraquinones, and substituted compounds of any of the foregoing. Various phenols can also be employed as inhibitors, the preferred one being p-methoxy phenol. In addition, alkyl or aryl phosphites may be employed, the preferred being triphenyl phosphite and trisodecyl phosphite.

The thickness, viscosity, or thixotropy of the composition can be varied in accordance with the particular application required. Thickeners, plasticizers, diluents, and various other reagents common to the art can be employed in any reasonable manner to produce the desired characteristics.

It is also optional that surfactants be present in the coating system for optimum performance. Suitable surfactants are those well known in the art and are those which are soluble in the coating and are non-reactive with the isocyanate-capped composition. Suitable surfactants include siloxanes and fluorocarbons. Other suitable surfactants include anionic materials such as petroleum sulfonates, sodium alkyl or alkylaryl sulfonates and sulfonated ethoxylated types.

Surfactant concentration will depend upon the particular surfactant and reactive diluent being used. Ordinarily, however, minimum concentration of about 0.01 percent surfactant by weight of the composition will be needed, and a concentration of about 0.5 or less percent usually will be preferred. Fluorocarbon and silicone surfactants are preferred. Hydrocarbon type surfactants can be used, as well.

Components (a) - (d) and any optional additives can be blended together simultaneously or the adduct (a) may be blended with the other components using conventional masterbatch techniques.

Once the desired components have been formulated, the one part composition can be applied to articles using conventional dipping, spraying, flood coat, curtain coat and brushing techniques.

The cure is believed to be best accomplished by the UV activation of the photoinitiator(s) (if these are present) that cleave into free radicals which initiates the polymerisation of the reactive diluents and the acrylate portion of the oligomer. A high intensity UV radiation source such as a medium pressure mercury arc lamp is the preferred source of the UV light. These high UV intensity light sources are preferred because they have sufficient intensity to overcome the various inhibitive effects found in free radical polymerized systems. These include the stabilizers/inhibitors added to improve storage stability but which tend to retard the bulk cure. The other major inhibitive effect is caused by oxygen in the air acting as a free radical trap that retards the surface cure, especially in thin, acrylate based coatings. The conformal coating of the present invention overcomes any tack-free surface cure problem such as in the partially shadowed areas around components, apparently due to the unique nature of the oligomer used, continued curing initiated by the UV treatment, and its secondary moisture cure. Any mild surface tack should disappear within 24-48 hours at ≥50% humidity.

This longer-term cure also polymerizes any of the liquid coating in the shadowed areas such as under components and leads that remain after initial cure.

The liquid coating material is somewhat "forgiving" to moisture exposure such as sometimes found in a production environment. Examples of the static pot life of the coating are illustrated in Example 8 where the coating was exposed to "standard" temperature conditions and at slightly elevated temperatures.

The static pot life of the liquid coating material was found to be most affected by large surface area to volume ratios in the reservoir. This would be expected since the atmospheric moisture diffuses from the exposed surface into the bulk of the coatings. But even at 1 to 3 surface to volume ratio, the liquid material was still usable after seven days at room temperature and 50% relative humidity. Commercial dip tanks typically have to surface ratios volume of greater than 1 to 12 which one would expect to have even longer pot life. An indication of this longer pot life is suggested with the 1 to 8 reservoir kept at 35°C/32% RH that had >12 days of usable pot life in the reservoir.

As with other isocyanate containing, dual curing compositions, the composition of this invention is cured through two mechanisms. The first cure is obtained by exposing the coating to radiation, preferably UV, to bring about crosslinking of the free ethylenically unsaturated groups. Then through exposure to moisture, preferably atmospheric moisture, crosslinking and chain extension of the free isocyanate groups in the composition occurs. In this manner, the exposed areas of the coating become "dry-to-the-touch", thereby permitting immediate handling of the coated article and maintaining the shape of the coating which might otherwise sag and creep. The secondary cure provides a substantially complete cure of the unexposed areas of the coating under conditions of ambient temperature and humidity.

In instances where the composition of this invention is used as a conformal coating on electronic circuit boards which have various components attached, the "dry-to-the-touch" curing is important in allowing the coated board to be further processed fairly soon after being coated. The secondary and tertiary cures provide a mechanism for curing the areas of coating which were shadowed from the radiation by the attached components. Articles having surface features which cause similar shadowing problems would also benefit.

In the alternative, a "dry-to-the-touch" cure is not required to ultimately produce a tack-free surface. Acrylate coatings which are UV curable tend to retain a tacky surface if not completely cured. The coating of this invention can be partially cured by exposure to UV. Any mild surface tack disappears within about 24-48 hours. This feature can allow a manufacturer to reduce costs by reducing the time or intensity of the UV treatment.

The coating of this invention also exhibits very good physical properties such as thermal, weather and hydrolytic stability. See Example 6. These features are especially important for electronic circuit board conformal coatings, which, as mentioned earlier, are continuously exposed to solvents, fluxes, handling etc. These properties would also be suitable for other applications for this invention, including, but not limited to, potting compounds and adhesives.

Potting is a variation on the coating process in which the coated item is placed inside a container which is filled with the coating formulation. Typically, the upper surface of the coating formulation is irradiated or heated and cured. (Of course, the container could be transparent to radiation.) This process can provide a very thick coating.

In order to further illustrate the practice of the present invention, the following examples are provided but are in no way meant to be limiting.

### Example 1

| Synthesis of Polyisocyanate Adduct | | |
|---|---|---|
| Reactants | Weight % | Grams |
| DESMODUR® N=3300^{a} | 88.72 | 625.0 |
| Hydroxyethyl acrylate^{b} | 10.73 | 75.6 |
| Triphenyl phosphite | 0.50 | 3.5 |
| p-methoxyphenol | 0.05 | 0.4 |
| TOTAL | 100.00 | 704.5 |

| | | |
|---|---|---|
| Footnotes: ^{a} - polyisocyanate (CAS 28182-81-20) from Mobay; based on 5.2 meq isocyanate (NCO)/g by titration (21.8% NCO). | | |
| ^{b} - ROCRYL® 420 hydroxyethyl acrylate (HEA) (CAS 818-6-1) from Rohm and Haas. Based on 8.6 meq hydroxyl (OH)/g with 20% of stoichiometric amount used. Dried over 4A molecular sieves before use. | | |

625 g of DESMODUR® N-3300 polyisocyanate was charged into a dried liter resin kettle equipped with a glass and teflon paddle stirrer, a stainless steel clad thermocouple, vented additional funnel and dry-air blanket. The polyisocyanate was charged in such a way as to minimize contact with moisture in the air. The polyisocyanate is heated to 45° - 50° C (113° to 122° F) while stirring at 200 rpm at which time 3.5 g triphenyl phosphite and 0.4g p-methoxyphenol were added to the kettle. The mixture was stirred five minutes with the kettle temperature allowed to increase to 55° C (131° F). The stirrer was increased to 400 rpm and 75.6g of HEA was then added dropwise via the addition funnel to the reaction mixture over 15 minutes (∼5g/min, average addition rate). The reaction mixture was allowed to exotherm from 55° C (131° F) to 65° C (149° F) during the HEA addition. After the HEA addition, the mixture temperature was allowed to rise to 85° - 90° C (185° - 194° F) by the exotherm and by additional heating. The mixture was then further stirred at 85° - 90° C (185° - 194° F) until the isocyanate value stabilized at 3.65 to 3.75 meq/q as measured by conventional titration techniques.

The resulting product was a clear to very slightly hazy colorless, somewhat viscous liquid at room temperature. The typical Brookfield RVT viscosity using a 14 spindle and a SC4-6R sample chamber at 25° C (77° F) is 11,500 centipoises (cps).

### Example 2

### Conformal Coating Formulations

Two coating formulations, A and B, based on the polyisocyanate/HEA adduct formed in Example 1 were formulated using master batches of (meth)acrylate monomers, photoinitiator and stabilizer. The materials and amounts of the monomer master batches and coatings A and B that were made include the following:

| Monomer Master Batches | | | | |
|---|---|---|---|---|
| | A | | B | |
| Components | Wt% | Grams | Wt% | Grams |
| SR-506 (isobornyl acrylate)^{a} | 38.6 | 320.0 | - | - |
| SR-395 (isodecyl acrylate)^{a} | - | - | 32.1 | 257.0 |
| SR-339 (phenoxyethyl acrylate)^{a} | 32.2 | 266.0 | 35.6 | 286.0 |
| QM-57 (dicyclopentenylethoxy methacrylate)^{b} | 25.9 | 214.0 | - | - |
| QM-672 (dicyclopentenylethoxy acrylate)^{b} | - | - | 28.6 | 229.0 |
| Irgacure 651^{c} | 3.2 | 26.6 | 3.6 | 28.6 |
| p-methoxyphenol (MEHQ) | 0.1 | 0.6 | 0.1 | 0.8 |
| TOTAL | 100.0 | 827.2 | 100.00 | 801.4 |

| | | | | |
|---|---|---|---|---|
| Footnotes: ^{a} - Sartomer Co. | | | | |
| ^{b} - Rohn and Haas | | | | |
| ^{c} - 2,2-dimethoxy-2-phenylacetophenone, Ciba-Geigy | | | | |

| Coatings | | | | |
|---|---|---|---|---|
| A | | | B | |
| Components | Wt% | Grams | Wt% | Grams |
| Desmodur® N-3300/HEA | 40.0 | 250.0 | 45.0 | 280.0 |
| Monomer Master Batch A | 60.0 | 375.0 | - | - |
| Monomer Master Batch B | - | - | 55.0 | 342.0 |
| TOTAL | 100.0 | 625.0 | 100.0 | 622.0 |

The monomers and MEHQ were charged into an amber glass bottle then shaken together until the MEHQ was dissolved. The IRGACURE® 651 photoinitiator was added and the mixture was shaken for five minutes more until the stabilizer and photoinitiator were dissolved. The monomer master batches were then dried by charging each with 40g of 4A molecular sieves (8-12 mesh), then allowed to stand in the sealed bottles for about four to six hours.

Two coatings were then formulated in a dry box (<15% relative humidity) to minimize contact with moisture. Contact with air was kept to a minimum. The adduct prepared according to Example 1 was then placed into a dry amber glass or plastic bottle, followed by the correct dried monomer master batch. The mixture was shaken at room temperature for five minutes until the oligomer was dissolved.

Both coatings (A and B) were clear, essentially colorless liquids. The Brookfield viscosities of A and B were each 115 cps. After seven weeks storage in sealed containers, viscosities were at about 125-130 cps, indicating the formulations were storage stable.

### Example 3

### Cured Coatings

Printed circuit boards (PCB) made from one 28.4 g copper and 1.6 mm core FR-4 with "dummy" surface mount devices (SMD) attached by tin-lead solder were cleaned using methods common to the electronics art. The PCB's were then dip coated with coatings A and B from Example 2 by immersion in a coating bath at a constant rate of 25.4 cm/min., then by withdrawing the coated part at about 10 cm/min.

The coated part was cured by exposure to UV radiation until the coating was dry-to-the-touch. The exposure technique included exposing each of the PCB to the UV using Colight Curing Unit (2 x 200 watt/in Hg lamps, belt speed of 30 ft/min). Each side (top and bottom) was given a total of 3 passes. The coating under the SMD's remained liquid while the exposed areas were tack-free. These coated, UV cured parts were then placed into a chamber with 100% R. H. for 48 hours then removed to an open room 30% R. H. for 13 days at which time one of the SMD's was removed for "A" and "B" coated boards. In each case the coating under the SMD part was tack-free.

### Example 4

Approximately 0.8g of each coating A and B from Example 2 in aluminum weighing dishes were placed in chambers maintained at 50% R.H. and 100% R.H. After 72 hours in the 100% R.H. chamber, both coatings were tack-free. The samples kept at 50% R.H. for 144 hours were also tack-free.

### Example 5

### Accelerated Moisture Cure

An accelerated moisture cure was conducted by adding 0.15g of a 1% (by wt.) solution of dibutylin dilaurate in isodecyl acrylate to 15g each of coating A and B. The moisture cures of those mixtures were tested in the same way as in Example 4. Both of these mixtures containing the dibutylin dilaurate were clear solids after 24 hours at 50% and 100% R.H. and were tack-free within 48 to 72 hours. When the moisture cure was tested at 30% R.H. both of these mixtures were tack-free after 48 hours while the coatings without the tin compound remained liquid. After 30 days storage in sealed plastic bottles, the viscosity of this composition went from 125 cps to 140 cps at 25° C.

### Example 6

### Properties of Cured Coating

Tests for the following properties were conducted on cured conformal coatings prepared according to Example 2 and cured by a method similar to the method described in Example 3, except that the method included techniques according to MIL-I-46058C. Specifically, the coated test specimens (coupons) were dipcoated at a 10 cm/minute immersion and withdrawal rate and were cured dry-to-the-touch by UV using four passes per side. After being UV cured, the specimens were placed in a humidity chamber (100% R.H.) for seventy-two hours. They were then removed and placed in an open room for at least twenty-four hours before testing. Both A and B passed the tests.
(1) Chemical Resistance: as measured by rubbing back and forth (1 double rub) a cotton swab soaked in methyl ethyl ketone across the coated specimen; the same test was again performed using a swab soaked in a mixture of freon and isopropyl alcohol; both A and B endured 100 double rubs for each solvent.
(2) Thermal Shock: as substantially measured by Military Specification MIL-I-46058C; both A and B passed fifty cycles of alternating exposure to -55°C and 125°C, with 17 cycles at -55°C to 125°C and 33 cycles at -65°C to 125°C.
(3) Moisture Resistance: as measured by Military Specification MIL-I-46058C; both A and B exhibited insulation resistance measurements of at least or greater than 10¹⁰ Ohms before, during and after the test which involves testing resistance under electrical load and under high humidity (90 - 95% R.H.) and temperatures of 25° C to 65° C.
(4) Dielectic Withstanding Voltage: as measured by Military Specification MIL-I-46058C; both A and B passed this test by having no disruptive discharge under test voltage of 1500 volts of alternating current at 60 hertz and with a current leakage of less than 10 microamperes.
(5) Insulation Resistance: as measured by Military Specification MIL-I-46058C and which was used as the insulation resistance prior to the moisture resistance test described in (3) above; both A and B passed having an insulation resistance of 2.0 x 10¹⁴ Ohms.

### Example 7

### Alternative Curing Method

Thin films of the present invention have the ability to cure a tack-free surface after a partial ultraviolet (UV) cure that leaves the coating surface still tacky. This ability of the tacky surface of the coating to become tack-free to the touch is believed to be possible via continued curing initiated by the UV treatment, or a secondary moisture cure mechanism such as described in Examples 3 and 4.

Formulation B of Example 2 was drawn down on the Hegman gauge with 0 to 25 µm deep groove (∼0.5 in. wide x ∼6 in. long) so that groove was filled with the formulation. The gauge was passed through a Colight UV Curing Unit for four passes at 30 ft/min. The coating was tack-free in 25 microns to ∼10 micron area of the Hegman gauge. The 10 micron thick to 0 micron thick areas of the coating remained tacky. The gauge with the UV exposed coating placed into a 95-100% relative humidity chamber for 24 hours at which time the area of the coating that was tacky after UV exposure was tack-free to the touch.

### Example 8

### Static Pot Life

Composition "B" from Example 2 was placed in the following plastic containers all kept open (no lids)

| Surface/Volume Ratio | Dimensions | Amount |
|---|---|---|
| 1:3 | 2.75 in. dia. x 3'' h | 230 g |
| 1:3.5 | 1.4 in. dia. x 3'' h | 110 g |
| 1:8 | 1.4 in. dia. x 8'' h | 100 g |

A set was placed in 24°C/50% relative humidity chamber and the other set placed in a 35°C/32% R.H chamber. Samples of each removed and measured on a Brookfield RVT viscometer at 25°C.

| | | | |
|---|---|---|---|
| Surface Area to Volume Ratios | 1:3 | 1:3.5 | 1:8 |
| Test Conditions | Viscosity @ 25°C | Viscosity @ 25°C | Viscosity @ 25°C |
| 24°C/50% R.H. | | | |
| 0 days | 100 cp | 110 cp | 110 cp |
| 3 days | 115 | NA | NA |
| 7 days | 140 | 125 | NA |
| 35°C/32% R.H. | | | |
| 0 days | 110 cp | 110 cp | 110 cp |
| 3 days | 115 (5%) | NA | NA |
| 7 days | 165 | 165 | 125 |
| 12 days | Gelled | Gelled | 150 |

### Example 9

### Multiple Cure Coating

Multiple cure coatings can be made according to the following methods. The Formulation B of Example 2 was blended with photoinitiator(s) and a stabilizer(s) to make formulations A, B & C listed in Example 9. They were tested for shelf stability by noting the initial viscosity and viscosity after 121 days.

| | Formulation | | |
|---|---|---|---|
| | A | B | C |
| Formulation B Example 2 | 300.0g | 300.0g | 200.0g |
| Irganox® 1520^{a} | 1.5g | - | - |
| Triphenyl phosphite | - | 1.5g | - |
| Irgacure 369^{b} | 0.3g | 0.3g | 0.2g |
| Quantacure ITX^{c} | 0.15g | 0.15g | 0.1g |
| Initial^{d} | 100 cps | 100 cps | 100 cps |
| 121 Days R.T. Storage | 150 cps | 150 cps | 150 cps |
| Dissolve together by shaking. | | | |

| | | | |
|---|---|---|---|
| Footnotes: ^{a} - Stabilizer, 6-methyl-2,4-Bis[(octylthio)-methyl]-phenyl, Ciba | | | |
| ^{b} - Photoinitiator; 4-morpholino-2-ethyl-2-dimethylamino-2-benzyl acetophenone; Ciba | | | |
| ^{c} - Photoinitiator, 2-isopropylthioxanthone. | | | |
| ^{d} - Brookfield viscosity @ 25°C, spindle #14 at 100 RPM. | | | |

According to these results, there is a nominal viscosity rise, from 100 to 150 cps. This is acceptable and the coatings remain usable for their intended applications. These formulations are dual-curing. That is, they are capable of UV and moisture cure. The formulations that result, A, B, and C, were further modified in Example 10 to provide an additional thermal curing mechanism as follows.

### Example 10

| | Formulation | | | | | |
|---|---|---|---|---|---|---|
| | 1 | 2 | 3 | 4 | 5 | 6 |
| Formulation A | 30.0g | - | 15.0g | 15.0g | 15.0g | 15.0g |
| Formulation B | - | 30.0g | - | 15.0g | 15.0g | 15.0g |
| Formulation C | - | - | 30.0g | - | - | - |
| Lupersol® PMS^{a} | - | - | - | 0.6g | - | - |
| Trigonox® 29B75^{b} | - | - | - | - | 0.4g | - |
| Lupersol® 575^{c} | 0.3g | 0.3g | 0.3g | - | - | 0.3g |
| Viscosity, cps Initial^{d} | 100 | 100 | 100 | 90 | 100 | 100 |
| 121 day R.T. storage | 150 | 140 | 140 | 125 | 150 | 150 |

| | | | | | | |
|---|---|---|---|---|---|---|
| Footnotes ^{a} - t-butyl peroctoate in 50% mineral spirits. | | | | | | |
| ^{b} - 1,1 bis(t-butylperoxy)3,3,5-trimethyl cyclohexane in DBP. | | | | | | |
| ^{c} - t-amyl peroxy-2-ethylhexanoate. | | | | | | |
| ^{d} - Brookfield viscosity @ 25°C, DVRVT spindle #14 at 100 RPM. | | | | | | |

The formulations A, B, C from Example 9 and the formulations 1 - 6 from Example 10 were each drawn down onto a 5 in. x 5 in. x 0.060 in. FR-4 (epoxyglass laminate) to - 2 mil on one end with the coatings allowed to puddle to a thicker coating -10 mil on the other end. Several dual in line (DIP) gull wing lead surface mount components (SHCTLS 374 IC) measuring approximately 0.5 in. x about 0.3 in. were placed in the thicker puddled coating of each formulation so that the coating formulations were in contact with the underside of the components. These coated samples with components were UV cured using three passes under a Fusion Systems lamp (10 inch H bulb) at a conveyor belt speed of 15 fpm (0.24 Joules/cm₂/pass). The exposed coatings were dry-to-the-touch while the coatings under the components remained liquid. The UV cured samples were then heated in a 85°C forced air oven for 15 minutes, removed from the oven and a component removed.

Formulations 1 - 6 from Example 10 were solid dry-to-the-touch under the components while the formulations A, B, C from Example 9 remained liquid after heating but solidified after 114 hours in a 80% RH humidity chamber. The material solidified by heat (formulations 1-6) became harder and tougher after exposure to humidity. This shows that shadowed areas can cure by heat or humidity.

The good storage stability of the formulations 1 - 6 containing thermal initiators in Example 10 are shown to have no increase in viscosity compared to the formulations without thermal initiators in Example 1.

## Claims

1. A one-part curable composition comprising
(a) an isocyanate adduct which is the reaction product of a polyisocyanate and a hydroxyalkyl (meth) acrylate, the adduct having (i) free isocyanate groups and (ii) free photopolymerisable ethylenically unsaturated groups, wherein the ethylenically unsaturated groups comprise in the range of 10 to 70% of the total of any free functional groups on said adduct;
(b) reactive (meth) acrylate diluents;
(c) optionally, photoinitiator; and
(d) an organic peroxide.

2. A composition according to claim 1 wherein the polyisocyanate is an aliphatic isocyanate trimer having an isocyanurate ring, preferably a trimerisation product of hexamethylene diisocyanate.

3. The composition of claim 1 or claim 2 wherein the organic peroxide is a peroxyester or peroxyketal or a mixture thereof.

4. The composition of claim 3 wherein the organic peroxide is t-butyl peroctoate, 1,1-bis(t-butylperoxy) 3,3,5-trimethyl cyclohexane, t-amyl peroxy-2-ethylhexanoate, or mixtures thereof.

5. The composition of any preceding claim wherein the photoinitiator is present and is 4-morpholino-2-ethyl-2-dimethylamino-2-benzyl acetophenone, 2-isopropyl thioxanthone, or 2-methyl-1-[4-(methylthio)phenyl]-2-morpholinopropanone or mixtures thereof.

6. The composition of any preceding claim further comprising a stabiliser, which is 6-methyl-2,4-bis{(octylthio)-methyl}-phenol, triphenylphosphite or mixtures thereof.

7. The composition of any preceding claim further comprising a surfactant which is a fluorocarbon, silicone, hydrocarbon, or mixtures thereof.

8. A multiple curable conformal coating composition comprising a composition according to any one of claims 1 to 7.

9. A method of providing a cured composition on an article wherein the method comprises
(a) applying to the article a composition according to any one of claims 1 to 7;
(b) curing the composition at least partially by exposing it to radiation.

10. A method according to claim 9 which is a method of providing a conformal coating on an article and wherein step (a) comprises applying to the article a coating comprising a composition according to any one of claims 1 to 7.

11. A method according to claim 10 wherein the method additionally comprises
(c) a secondary curing step wherein parts of the composition not exposed to radiation in step (b) are cured by initiating secondary curing.

12. A method according to claim 11 in which the secondary curing is initiated by the application of heat to the composition and/or by contacting the composition with moisture.

13. A method according to claim 12 wherein step (c) is carried out at a temperature sufficient to activate the organic peroxide.

14. A method of potting comprising use of a composition according to any one of claims 1 to 7.

## Patentansprüche

1. Härtbare Einkomponenten-Zusammensetzung, umfassend
(a) ein Isocyanat-Addukt, bei dem es sich um das Reaktionsprodukt eines Polyisocyanats und eines Hydroxyalkyl(meth)acrylats handelt, wobei das Addukt (i) freie Isocyanat-Gruppen und (ii) freie photopolymerisierbare ethylenisch ungesättigte Gruppen aufweist, worin die ethylenisch ungesättigten Gruppen 10 bis 70% der Summe aller freien funktionellen Gruppen an dem Addukt umfassen;
(b) reaktive (Meth)acrylat-Verdünnungsmittel;
(c) gegebenenfalls Photoinitiator; und
(d) ein organisches Peroxid.

2. Zusammensetzung nach Anspruch 1, worin das Polyisocyanat ein aliphatisches Isocyanat-Trimer mit einem Isocyanurat-Ring, vorzugsweise ein Trimerisationsprodukt von Hexamethylendiisocyanat, ist.

3. Zusammensetzung nach Anspruch 1 oder Anspruch 2, worin das organische Peroxid ein Peroxyester oder Peroxyketal oder eine Mischung davon ist.

4. Zusammensetzung nach Anspruch 3, worin es sich bei dem organischen Peroxid um t-Butylperoctoat, 1,1-Bis(t-butylperoxy)-3,3,5-trimethylcyclohexan, t-Amylperoxy-2-ethylhexanoat oder Mischungen davon handelt.

5. Zusammensetzung nach irgendeinem vorhergehenden Anspruch, worin der Photoinitiator vorhanden ist und es sich um 4-Morpholino-2-ethyl-2-dimethylamino-2-benzylacetophenon, 2-lsopropylthioxanthon oder 2-Methyl-1-[4-(methylthio)phenyl]-2-morpholinopropanon oder Mischungen davon handelt.

6. Zusammensetzung nach irgendeinem vorhergehenden Anspruch, welche weiter einen Stabilisator umfaßt, bei dem es sich um 6-Methyl-2,4-bis{(octylthio)-methyl}-phenol, Triphenylphosphit oder Mischungen davon handelt.

7. Zusammensetzung nach irgendeinem vorhergehenden Anspruch, welche weiter ein Tensid umfaßt, bei dem es sich um einen Fluorkohlenstoff, Silicon, Kohlenwasserstoff oder Mischungen davon handelt.

8. Mehrfach härtbare konforme Beschichtungszusammensetzung, umfassend eine Zusammensetzung nach irgendeinem der Ansprüche 1 bis 7.

9. Verfahren zur Bereitstellung einer gehärteten Zusammensetzung auf einem Gegenstand, worin das Verfahren
(a) Aufbringen einer Zusammensetzung nach irgendeinem der Ansprüche 1 bis 7 auf den Gegenstand;
(b) zumindest teilweises Härten der Zusammensetzung, indem man sie Strahlung aussetzt;
umfaßt.

10. Verfahren nach Anspruch 9, bei welchem es sich um ein Verfahren zur Bereitstellung einer konformen Schicht auf einem Gegenstand handelt und worin Schritt (a) das Aufbringen einer Schicht, die eine Zusammensetzung nach irgendeinem der Ansprüche 1 bis 7 umfaßt, auf den Gegenstand umfaßt.

11. Verfahren nach Anspruch 10, worin das Verfahren zusätzlich
(c) einen sekundären Härtungsschritt, worin Teile der Zusammensetzung, die in Schritt (b) nicht der Strahlung ausgesetzt wurden, durch Initiieren einer sekundären Härtung gehärtet werden,
umfaßt.

12. Verfahren nach Anspruch 11, worin die sekundäre Härtung durch Anwendung von Wärme auf die Zusammensetzung und/oder durch Kontaktieren der Zusammensetzung mit Feuchtigkeit initiiert wird.

13. Verfahren nach Anspruch 12, worin Schritt (c) bei einer Temperatur durchgeführt wird, die ausreicht, um das organische Peroxid zu aktivieren.

14. Pottingverfahren, umfassend die Verwendung einer Zusammensetzung nach irgendeinem der Ansprüche 1 bis 7.

## Revendications

1. Composition durcissable à un seul composant, comprenant :
(a) un produit d'addition d'isocyanate qui est le produit de la réaction d'un polyisocyanate et d'un hydroxyalkyl(méth)acrylate, le produit d'addition ayant (i) des groupes isocyanates libres et (ii) des groupes à insaturation éthylénique photopolymérisables libres, tels que les groupes à insaturation éthylénique forment 10 à 70 % du total des groupes fonctionnels libres du produit d'addition,
(b) des diluants réactifs de (méth)acrylate,
(c) éventuellement un photoinducteur, et
(d) un peroxyde organique.

2. Composition selon la revendication 1, dans laquelle le polyisocyanate est un trimère d'isocyanate aliphatique ayant un noyau isocyanurate, de préférence un produit de trimérisation d'un diisocyanate d'hexaméthylène.

3. Composition selon la revendication 1 ou 2, dans laquelle le peroxyde organique est un peroxyester ou un peroxycétal ou un de leurs mélanges.

4. Composition selon la revendication 3, dans laquelle le peroxyde organique est le peroctoate de t-butyle, le 1,1-bis(t-butylperoxyde)3,3,5-triméthylcyclohexane, le peroxy-2-éthylhexanoate de t-amyle ou un de leurs mélanges.

5. Composition selon l'une quelconque des revendications précédentes, dans laquelle le photoinducteur est présent et est formé de 4-morpholino-2-éthyl-2-diméthylamino-2-benzylacétophénone, de 2-isopropylthioxanthone ou de 2-méthyl-1-[4-(méthylthio)phényl]-2-morpholinopropanone ou d'un de leurs mélanges.

6. Composition selon l'une quelconque des revendications précédentes, comprenant en outre un agent stabilisant formé de 6-méthyl-2,4-bis{(octylthio)méthyl}-phénol, de triphénylphosphite ou d'un de leurs mélanges.

7. Composition selon l'une quelconque des revendications précédentes comprenant en outre un agent tensioactif qui est une substance fluorocarbonée, une silicone, un hydrocarbure ou un de leurs mélanges.

8. Composition de revêtement multiple durcissable prenant la forme et comprenant une composition selon l'une quelconque des revendications 1 à 7.

9. Procédé de formation d'une composition durcie sur un article, le procédé comprenant :
(a) l'application à l'article d'une composition selon l'une quelconque des revendications 1 à 7, et
(b) le durcissement de la composition au moins partiellement par exposition à un rayonnement.

10. Procédé selon la revendication 9, qui est destiné à former un revêtement prenant la forme d'un article, et dans lequel l'étape (a) comprend l'application à l'article d'un revêtement comprenant une composition selon l'une quelconque des revendications 1 à 7.

11. Procédé selon la revendication 10, dans lequel le procédé comprend en outre
(c) une étape de durcissement secondaire dans laquelle les parties de la composition qui ne sont pas exposées au rayonnement dans l'étape (b) sont durcies par déclenchement d'un durcissement secondaire.

12. Procédé selon la revendication 11, dans lequel le durcissement secondaire est déclenché par application de chaleur à la composition et/ou par mise en contact de la composition avec de l'humidité.

13. Procédé selon la revendication 12, dans lequel l'étape (c) est exécutée à une température suffisante pour provoquer l'activation du peroxyde organique.

14. Procédé d'enrobage comprenant l'utilisation d'une composition selon l'une quelconque des revendications 1 à 7.
